# EUROPÄISCHE PATENTSCHRIFT

(11) **EP 1 525 611 B1**
(45) Veröffentlichungstag und Bekanntmachung des Hinweises auf die Patenterteilung: **24.01.2007**
(21) Anmeldenummer: 03756972.0
(22) Anmeldetag: 10.06.2003
(51) Int. Cl.: H01L 21/768, H01L 21/285

(54) **VERFAHREN ZUR FÜLLUNG VON GRABEN- UND RELIEFGEOMETRIEN IN HALBLEITERSTRUKTUREN**
METHOD FOR FILLING TRENCH AND RELIEF GEOMETRIES IN SEMICONDUCTOR STRUCTURES
PROCEDE DE REMPLISSAGE DE TRANCHEES ET DE RELIEFS DANS DES STRUCTURES DE SEMI-CONDUCTEUR

(30) Priorität: 11.06.2002 DE 10225941
(43) Veröffentlichungstag der Anmeldung: 27.04.2005
(73) Patentinhaber: Infineon Technologies AG, 81669 München (DE)
(72) Erfinder: TEMMLER, Dietmar, 01109 Dresden (DE); LORENZ, Barbara, 01109 Dresden (DE); KOEHLER, Daniel, 09113 Chemnitz (DE); FOERSTER, Matthias, 01099 Dresden (DE)
(74) Vertreter: Hudler, Frank
(86) Internationale Anmeldenummer: PCT/DE2003/001923
(87) Internationale Veröffentlichungsnummer: WO 2003/105220

(56) Entgegenhaltungen:
- US-A- 4 666 737
- US-A- 5 346 585
- US-A- 5 451 809
- US-A- 5 904 561
- US-A- 5 933 746
- US-A- 6 030 881
- US-A- 6 077 786
- US-A- 6 124 203
- US-B1- 6 191 026
- US-B1- 6 287 964
- PATENT ABSTRACTS OF JAPAN vol. 1995, no. 09, 31. Oktober 1995 (1995-10-31) & JP 07 161703 A (RICOH CO LTD), 23. Juni 1995 (1995-06-23)

## Beschreibung

Die Erfindung betrifft ein Verfahren zur Füllung von in einem Halbleitersubstrat ausgebildeten Graben- und Reliefstrukturen, bei dem die Graben- und Reliefstrukturen in einem ersten Abscheideprozess mit einer ersten primären Füllschicht mit hoher Konformität und minimaler. Rauhigkeit beschichtet werden, wobei nachfolgend eine bis in eine vorgegebene Tiefe der Grabenstruktur gehende V-Ätzung zur Erzeugung eines V-Profiles vorgenommen wird und eine zweite primäre Füllschicht mit hoher Konformität und minimaler Rauhigkeit abgeschieden wird.

Mit der ständigen Skalierung von Halbleiterbauelementen nimmt in der Regel auch das Aspektverhältnis (Tiefe / Breite) der auf Substraten ausgebildeten Graben- und Reliefstrukturen darin zu. Bei einem Strukturniveau von < 100 nm werden dabei zum Teil Öffnungswinkel um 0,1° erreicht. Die geringen Öffnungswinkel machen es zunehmend schwieriger, diese extrem steilen Profile zu füllen. Obwohl hochkonforme Abscheideverfahren (nahe 100 %) für die verschiedensten leitenden oder isolierenden Füllschichten speziell entwickelt worden sind, kommt es durch geringste fertigungsbedingte Profilschwankungen zum Auftreten von nicht ideal geschlossenen Schließfugen (Voids) entlang der Mittelachse solcher gefüllter Graben- und Reliefstrukturen.

Die besonderen Nachteile solcher Voids sind darin zu sehen, dass diese den geometrischen Querschnitt leitfähiger Füllungen unkontrolliert verringern und dadurch deren elektrischen Widerstand erhöhen oder andere Parameter nachteilig beeinflussen. So werden Speicherkondensatoren für DRAM-Zellen beispielsweise durch Deep-Trench-Ätzen, dielektrischer Beschichtung der Grabenwände und anschließender Füllung des Trenches mit einem leitfähigen Material hergestellt. Voids in dieser leitfähigen Füllung erhöhen deren Widerstand unkontrolliert.

Für den häufig auftretenden Fall, dass Füllungen von Gräben bzw. Reliefs aus funktionellen Gründen oberflächlich planarisiert oder (teilweise) rückgeätzt werden müssen (Recess Ätzen), führen Voids in der Füllung in Abhängigkeit von ihrer Größe zu lokalen Schwankungen in der Planarisierungs- bzw. Recess-Ätzrate. Das führt zu nicht kontrollierbaren Schwankungen für die Tiefenlage und das Profil der planarisierten bzw. Recess-Flächen. In der Regel wird dabei der Voidbereich in Breite und Tiefe deutlich vergrößert. Das hat unter Umständen Auswirkungen auf die weitere Prozessierung und die Parameter dieser Anordnungen, indem ein nicht reproduzierbares (V-förmiges) Relief der Planarisierungs- bzw. Recess-Oberfläche der Primärfüllung in einer folgenden Schichtabscheidung reproduziert wird. Falls dann die Folgeschicht mittels anisotroper RIE-Ätzung (reaktives Ionenätzen) auf der Recess-Oberfläche wieder entfernt werden soll, gelingt das nicht vollständig. Die Ursache hierfür liegt darin, dass das Schichtmaterial der Folgeschicht bis tief in den Voidbereich hinein abgelagert worden ist. Das führt dann zu elektrischen Kurzschlüssen (bei isolierter Füllschicht und leitfähiger Folgeschicht) bzw. zu Unterbrechungen im Strompfad (bei leitfähiger Füllschicht und isolierender Folgeschicht und kann zusätzlich als Partikel- und Kontaminationsquelle bei der weiteren Prozessierung wirken.

Die Entstehung dieser Voids wurde bisher durch ein ausreichend V-förmiges Profil der Graben- bzw. Reliefstrukturen vermieden. Bei einer hochkonformen Abscheidung der Füllschicht wächst diese an ihrer Nahtstelle dadurch von unten nach oben voidfrei zu. Durch die weitere Skalierung der Strukturen kann der Flächenbedarf für die Wandneigung der Graben- bzw. Reliefstrukturen nicht mehr aufgebracht werden. Die reproduzierbare Einstellung sehr steiler Flanken der Graben- bzw. Reliefstrukturen ist extrem problematisch, wodurch diese Methode zunehmend versagt.

Eine andere praktisch erprobte Möglichkeit, das Void unabhängig vom Profil der Graben- oder Reliefstrukturen nachträglich zu schließen, besteht in der Anwendung einer zusätzlichen, dünnen konformen Abscheidung (Divot fill) aus dem gleichen Materialtyp (leitfähig oder isolierend) wie die primäre Füllschicht und anschließendes (nasschemisches) Entfernen der auf der SubstratOberfläche und an den Seitenwänden der Reliefstruktur abgeschiedenen Divot-Fill-Schicht.

Dabei ist von Nachteil, dass die vor dem Divot-Fill erfolgenden Recess-Ätzungen nicht verbessert werden. Vor allem aber ist das Prozessfenster der Recess-Ätzung des Divot-Fill sehr klein. Entweder bleiben danach Reste auf der Substratoberfläche und den Wänden der Graben- oder Reliefstrukturen, oder das Void wird wieder vollständig oder zumindest teilweise geöffnet.

Aus der US 6 359 300 A ist ein Deep-Trench-Kondensator in einem Wafer mit voidfreier Füllung bekannt. Der Trench-Kondensator umfasst ein Substrat, einen im Substrat ausgebildeten Trench und ein leitfähiges Füllmaterial, welches den Trench vollständig ausfüllt und aus dotiertem Germanium oder einer Silizium-Germanium-Legierung besteht.

Um eine voidfreie Füllung zu erreichen, wird das leitfähige dotierte Germanium oder die Silizium-Germanium-Legierung im Trench abgeschieden und eine Füllschicht auf dem Substrat erzeugt. Anschließend wird der Wafer erwärmt, bis die Füllschicht schmilzt und vollständig in den Trench fließt.

Ein derartiges Verfahren ist.für Polysilizium-, SiO2- oder Metall-Füllschichten wegen der erforderlichen hohen Temperaturen nicht praktikabel.

Die US-A-4 666 737 beschreibt das Metallisieren von tiefen Vias in einer isolierenden Schicht. Dabei werden die Graben- und Reliefstrukturen in einem ersten Abscheideprozess mit einer ersten primären konformen Schicht aus Wolfram beschichtet. Danach wird eine bis in eine vorgegebene Tiefe der Grabenstruktur gehende plasmachemische V-Ätzung vorgenommen, um ein V-Profil zu erzeugen. Eine zweite primäre konforme Füllschicht aus Aluminium wird anschließend abgeschieden, bis die Graben- und Reliefstruktur vollständg geschlossen ist. Dieses Verfahren ist jedoch zur Füllung von besonders tiefen Graben- und Reliefstrukturen nicht geeignet.

Ein alternatives Verfahren geht aus den PATANT ABSTRACTS OF JAPAN vol. 1995, no. 09, 31. Oktober 1995 (1995-10-31) & JP 07 161703 A hervor.

Aus der US-A-5 451 809 geht ein Verfahren zum Herstellen von Trenchkondensatoren hervor, bei dem der Trench mit einem leitfähigen Silizium durch Mehrtachbeschichten abwechselnd mit Rückätzen gefüllt wird.

Der Erfindung liegt nunmehr die Aufgabe zugrunde, ein Verfahren zur Füllung von Graben- und Reliefstrukturen in Halbleiterstrukturen zu schaffen, mit dem das Entstehen von Voids sicher vermieden werden kann und das einfach und kostengünstig realisiert werden kann.

Die der Erfindung zugrundeliegende Aufgabe wird durch die kenn zeichnenden Merkmale des Patentanspruchs 1 gelöst. Eine besondere Ausgestaltung der Erfindung geht aus Patentanspruch 2 hervor.

Weitere Merkmale der Erfindung gehen aus den weiteren Unteransprüchen hervor.

Die Vorteile des erfindungsgemäßen Verfahrens sind darin zu sehen, dass eine vollständig voidfreie Verfüllung skalierter Graben- und Reliefstrukturen von Anfang an, entkoppelt vom Profil der Graben- und Reliefstrukturen erreicht wird. Insbesondere auch bei beliebig steilem, durch Prozesstoleranzen schwankendem Wandprofil der Graben- und Reliefstrukturen bzw. auch bei negativem (überhängendem) Profil der Graben- und Reliefstruktur lässt sich eine voidfreie Füllung erreichen.

Auch werden die eingangs beschriebenen Folge-Nachteile vermieden und durch die Entkopplung des Füllprozesses vom Ausgangsprofil der Graben- und Reliefstruktur eine Erhöhung der Prozessstabilität bei der weiteren Prozessierung erreicht.

Auch werden nachträgliche Void-"Reparaturschritte" (Divot-Fill) und die damit verbundenen Probleme vermieden.

Vorteilhaft ist auch die Integrierbarkeit einer vorteilhaften Polysilizium-Metall-Füllung für den Applikationsfall der Speichertrenchfüllung und die Einstellung vorteilhafter Kontaktfensterprofile für den Applikationsfall Isolationsgap-Füllung.

Die Erfindung soll nachfolgend an einem Ausführungsbeispiel näher erläutert werden. In den zugehörigen Zeichnungen zeigen:
- Fig. 1a ...e:: eine zweistufige Trenchfüllung mit einem V-Ätzschritt nach der ersten Füllschichtabscheidung am Beispiel von Trench-Speicherzellen; und
- Fig. 2a...i:: ein Ausführungsbeispiel des erfindungsgemäßen Verfahren, nämlich eine zweistufige Trenchfüllung mit nach der ersten Füllschichtabscheidung abgeschiedener Füllhilfsschicht und nachfolgendem Bias-Ätzschritt am Beispiel von Trench-Speicherzellen;

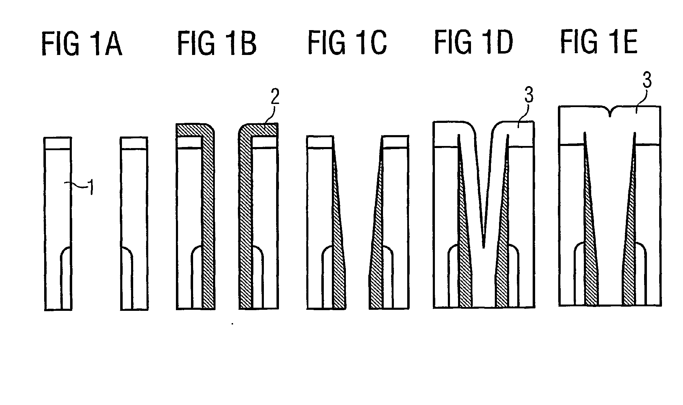

In Fig. 1a ist ein Halbleitersubstrat 1 mit einer bereits präparierten Graben- und Reliefstruktur schematisch dargestellt, die mit dem Verfahren, dargestellt in den Fig. 1b ...e, zu füllen ist. Entsprechend Fig. 1b wird in die Graben- und Reliefstruktur eine erste Füllschicht, bestehend aus undotiertem, amorphen Silizium mit extrem glatter Oberfläche abgeschieden. Danach wird in dieser Si-Schicht ein V-Profil (Fig. 1c) mittels eines vorzugsweise plasmachemischen Ätzschrittes ausgebildet. Bei diesem Ätzschritt ist die Ätzrate so eingestellt, dass diese in die Tiefe des Trenches gegenüber der Ätzrate an der Oberfläche deutlich abnehmend ist und in der Tiefe 400...1000 nm auf Null absinkt (ARDE: aspect ratio depended etch / RIE lag). Anschließend wird die V-geätzte Si-Schicht mittels Gasphasendotierung, vorzugsweise mittels Arsin, hoch dotiert.

Nachfolgend wird dieses V-Profil durch eine zweite Füllschicht 3 aufgefüllt (Fig. 1 d, e), indem undotiertes amorphes Silizium mit extrem glatter Oberfläche abgeschieden wird, dessen elektrische Leitfähigkeit dadurch realisiert wird, dass während der Temperaturschritte des folgenden Integrationsprozesses ausreichend As aus der ersten Füllschicht 2 in die zweite Füllschicht 3 ausdiffundiert.

Die extrem glatten Oberflächen der beiden amorph abgeschiedenen Silizium-Füllschichten 2, 3 dienen dazu, die Schließfuge in der Füllung der Trenchstruktur ideal glatt und völlig voidfrei zu gestalten.

In einer Variante dieses Verfahrens besteht die erste Füllschicht 2 aus undotiert abgeschiedenem amorphen Silizium mit extrem glatter Oberfläche, das später mittels Gasphasendiffusion hoch As-dotiert wird. Die zweite Füllschicht 3 ist eine metallische Schicht, vorzugsweise aus einem hochschmelzenden Material mit extrem glatter Oberfläche.

Die extrem glatten Oberflächen der beiden Füllschichten dienen dazu, die Schließfuge in der Füllung der Trenchstruktur ideal glatt und völlig voidfrei zu gestalten.

Die Kombination der Trenchfüllung aus Poly-Silizium (erste Schicht 2) direkt an der dielektrischen Schicht mit metallischem Kern (zweite Schicht 3)im Zentrum der Trenchstruktur, ist hinsichtlich Leitfähigkeit, Stabilität / Integrität und minimaler Leckströme für die Trenchspeicherkapazität besonders vorteilhaft.

### Ausführungsbeispiel

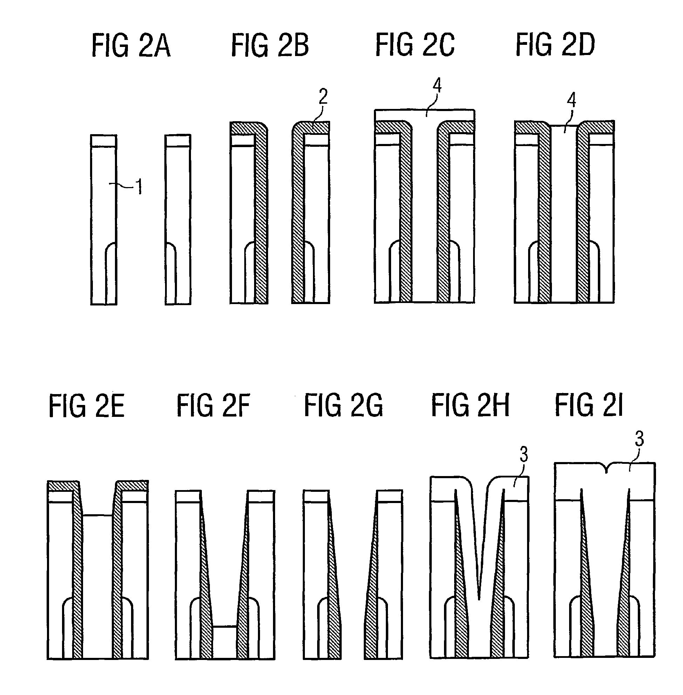

Die einzelnen Schritte der Trenchfüllung sind aus den Fig. 2a...2i ersichtlich. Ausgangspunkt ist wieder eine bereits präparierte Graben- und Reliefstruktur, wie in Fig. 2a dargestellt.

Die Herstellung des V-Profiles in der ersten Füllschicht 2 erfolgt dadurch, dass über der ersten Füllschicht 2 zunächst eine Füllhilfsschicht 4, vorzugsweise dotiertes SiO2, abgeschieden wird (Fig. 2c), die anschließend auf der Substratoberfläche planarisierend wieder entfernt wird (Fig. 2d).

Danach folgt ein vorwiegend isotrop wirkender nasschemischer Ätzschritt (Bias Ätzung), dessen Abtragsrate für das Material der Füllhilfsschicht 5..20x größer ist, als für das Material der ersten Füllschicht 2 (Fig. 2e).

Auf diese Weise wird bis zum Moment des vollständigen Abtrags der ersten Füllschicht 2 auf der Substratoberfläche im Trench ein V-Profil in der ersten Füllschicht 2 bis in die Tiefe ausgebildet, das außer von der Ätzzeit zur vollständigen Entfernung der ersten Füllschicht 2 von der Substratoberfläche, nur noch von der Ätzrate des Materiales der Füllhilfsschicht 4 abhängt.

Nach Erreichen dieses Prozessstadiums wird die Bias-Ätzung eingestellt und eine weitere, vorwiegend isotrope nasschemische Ätzung angewendet, die das im Trench verbliebene Material der Füllhilfsschicht 4 mit hoher Selektivität zur ersten Füllschicht 2 aus dem Trench wieder vollständig herauslöst (Fig. 2f).

In einer Variante dieses Ausführungsbeispieles wird die Bias-Ätzung ersetzt durch eine Mehrschritt-Ätzung, bei der die erste Füllschicht 2 und die Füllhilfsschicht 4 im Wechsel, mit einer jeweils speziellen Ätzlösung, hochselektiv zur jeweils anderen Schicht um einen gewissen (kleinen) Dickenbetrag pro Ätzschritt abgeätzt wird. Diese Mehrschritt-Ätzung wird bis zum vollständigen Abtrag der ersten Füllschicht 2 auf der Substratoberfläche durchgeführt.

Diese Verfahrensweise hat gegenüber der Einschritt-Bias-Ätzung eine Reihe von Vorteilen. So können die beiden Ätzlösungen ohne Kompromiss auf eine hochselektive Ätzung nur jeweils des Materiales der ersten Füllschicht 2 bzw. der Füllhilfsschicht 4 konfektioniert werden. Bei der Bias-Ätzung muss dagegen die Zusammensetzung und die Temperatur der Ätzlösung sehr genau auf ein vorgegebenes Ätzrateverhältnis von erster Füllschicht 2 und Füllhilfsschicht 4 eingestellt werden.

Ein weiterer Vorteil ist, dass der jeweilige Dickenabtrag von erster Füllschicht 2 und Füllhilfsschicht 4 während eines Ätzschrittes durch die Ätzzeit sehr genau eingestellt und nachkorrigiert werden kann. Bei der Bias-Ätzung muss dies dagegen durch die Zusammensetzung und Temperatur der Ätzlösung realisiert werden.

Schließlich kann die Durchführung zyklischer Ätzschrittfolgen mit unterschiedlichen Ätzlösungen entsprechend dem Stand der Technik sehr effektiv durch programmierte automatische Ätzanlagen mit hoher Präzision erfolgen.

Der anschließend notwendige Ätzschritt zur Entfernung des restlichen, im Trench verbliebenen Materiales der Füllhilfsschicht 4 mit hoher Selektivität zur ersten Füllschicht 2 ist bezüglich der Ätzlösung mit der während der Mehrschritt-Ätzung der Füllhilfsschicht 4 eingesetzten Ätzlösung identisch und kann im programmierten Ablauf des Mehrschritt-Ätzprozesses einfach integriert werden.

Nachfolgend wird wie im Verfahren gemäß Figur 1 dieses V-Profil durch eine zweite Füllschicht 3 aufgefüllt (Fig. 2h, i), indem undotiertes amorphes Silizium mit extrem glatter Oberfläche abgeschieden wird.

Bezüglich der Füllschichten sind die gleichen speziellen Ausführungen wie im Verfahren gemäß figur 1 vorteilhaft anwendbar.

### Beispiel 1

Weiter Beispiele, die nicht in den Auwendungsbereich der Erfindung Fallen, werden im Folgenden beschrieben.

Bei diesem Beispiel wird das Auftreten von Voids in STI-Füllungen (shallow trench isolation) verhindert. Diese Ausführungsbeispiel wird ohne Bezugnahme auf eine zeichnungsfigur beschrieben.

Die Herstellung des gewünschten V-Profiles in der ersten Füllschicht (vorzugsweise SiO2) erfolgt mittels eines Ätzschrittes, dessen Abtragsrate in der Tiefe der Isolationstrenches gegenüber der Abtragsrate an der Oberfläche des STI-Profiles deutlich abnehmend ist, so dass das Profil oberflächlich stärker aufgeweitet wird, als in dessen Tiefe.

Damit wird eine günstige Reliefform geschaffen, die eine vollständig voidfreie Füllung mit der zweiten Füllschicht (vorzugsweise SiO2) erlaubt. Danach erfolgt die Planarisierung der STI-Isolation und die weitere Prozessierung auf konventionelle Weise.

### Beispiel 2

Hier wird die 2-stufige Füllung der Isolationsgap-Zwischenräume zwischen benachbarten Gate-/Wortleitungs- bzw. Metallisierungsbahnen mit einem V-Ätzschritt nach der ersten Füllschichtabscheidung ohne Bezugnahme auf eine Zeichnung beschrieben.

Die Herstellung des gewünschten V-Profiles in der ersten Füllschicht (vorzugsweise Si02) erfolgt mit einem ersten Ätzschritt, dessen Ätzrate in der Tiefe der Isolationsgaps zwischen benachbarten Bahnen gegenüber der Abtragsrate an der Oberfläche des GAP-Profiles (gap isolation) deutlich abnehmend ist. Dadurch wird das Profil oberflächlich stärker aufgeweitet, als in dessen Tiefe, wodurch eine günstige Reliefform geschaffen wird. Diese Reliefform erlaubt eine vollständig voidfreie Füllung mit einer zweiten Füllschicht (vorzugsweise SiO2). Danach erfolgt die Planarisierung der Gapfill-Isolation und die weitere Prozessierung auf konventionelle Art.

In einer Variante des Verfahrens wird die erste Füllschicht durch undotiertes SiO2 realisiert und die zweite Füllschicht als dotiertes Si02 ausgebildet. Durch die Nutzung der Abhängigkeit der Ätzrate des Kontaktfensterprozesses von der Dotierung des Gapfill-Isolators kann das Profil der Kontaktfenster in der folgenden Kontaktfensterebene mindestens in Richtung der am engsten benachbarten Bahnen selbstjustierend günstig gestaltet werden. Dadurch wird die Häufigkeit von Kurzschlüssen zwischen den Kontaktplugs dieser Kontaktfensterebene und den Bahnen reduziert.

### Beispiel 3

Es wird nachfolgend eine 2-stufige Kontaktplug-Füllung mit einem V-Ätzschritt nach der ersten Füllschichtabscheidung ohne Bezugnahme auf eine Zeichnung beschrieben, mit dem das Auftreten von Voids in der leitfähigen Füllung von Kontaktfenstern vermieden wird.

Die Herstellung des V-Profiles in der ersten Füllschicht (hier vorzugsweise Polysilizium) erfolgt hier mittels eines Ätzschrittes, dessen Abtragsrate in der Tiefe der Kontaktfenster gegenüber der Abtragsrate an der Oberfläche des Kontaktfenster-Profiles deutlich abnehmend ist. Damit wird das Kontaktfenster-Profil im Oberflächenbereich stärker aufgeweitet, als in dessen Tiefe. Damit wird eine günstigere Reliefform geschafen, die eine voidfreie Füllung mit der zweiten Füllschicht (hier vorzugsweise Metall) erlaubt.

In einer Variante diese Ausführungsbeispieles ist auch die erste Füllschicht metallisch und besteht bevorzugt aus einem Schichtstapel aus einer dünnen Barriereschicht und einer metallischen Füllschicht.

Für den Fall, dass die Kontaktplugs als von der folgenden Me*tallisierungsschicht* separiertes Schichtsystem ausgebildet werden, erfolgt danach die Planarisierung der Kontaktfüllung und danach die weitere Prozessierung, d.h. Abscheidung und Strukturierung der Metallisierungsschicht, auf konventionelle Weise.

Für den Fall, dass die Kontaktplugs als Teil der Metallisierungsschicht im selben Schichtsystem wie diese ausgebildet werden, erfolgt nach der Abscheidung der ersten Füllschicht die V-Ätzung, danach die Abscheidung der 2. Füllschicht und danach die Strukturierung der Metallisierungsschicht in konventioneller Art.

### Bezugszeichenliste

- 1: Halbleitersubstrat mit Graben- bzw. Reliefstruktur
- 2: erste Füllschicht
- 3: zweite Füllschicht
- 4: Füllhilfsschicht

## Patentansprüche

1. Verfahren zur Füllung von in einem Halbleitersubstrat ausgebildeten Graben- und Reliefstrukturen, bei dem die Graben- und Reliefstrukturen in einem ersten Abscheideprozess mit einer ersten primären Füllschicht (2) mit hoher Konformität und minimaler Rauhigkeit beschichtet werden, wobei nachfolgend eine bis in eine vorgegebene Tiefe der Grabenstruktur gehende V-Ätzung zur Erzeugung eines V-Profiles vorgenommen wird und eine zweite primäre Füllschicht (3) mit hoher konformität und minimaler Rauhigkeit abgeschieden wird, **dadurch gekennzeichnet, dass** nach der Abscheidung der ersten Füllschicht (2) und vor der Ausbildung des V-Profiles auf der ersten primären Füllschicht eine Füllhislfsschicht (4) abgeschieden wird, die anschließend auf der Substratoberfläche planarisierend wieder entfernt wird, dass zur Ausbildung des V-Profiles ein vorwiegend isotrop wirkender nasschemischer Ätzschritt bis zum vollständigen Abtrag der ersten Füllschicht (2) auf der Oberfläche des Halbleitersubstrates (1) ausgeführt wird, dass anschließend eine nasschemische Ätzung ausgeführt wird, die das in der Graben- und Reliefstruktur verbliebene Material der Füllhilfsschicht (4) mit hoher Selektivität zur ersten Füllschicht (2) wieder vollständig entfernt und dass danach die zweite primäre Füllschicht (3) abgeschieden wird, bis die Graben- und Reliefstruktur vollständig geschlossen ist.

2. Verfahren nach Anspruch 1, **dadurch gekennzeichnet, dass** die Füllhilfsschicht (4) aus dotiertem SiO2 besteht.

3. Verfahren nach einem der Ansprüche 1 und 2, **dadurch gekennzeichnet, dass** die erste Füllschicht in einer Dicke abgeschieden wird, die etwa 10 - 30% der Breite der Graben- und Reliefstruktur entspricht.

4. Verfahren nach Anspruch 1, **dadurch gekennzeichnet, dass** die zweite Füllschicht (3) in einer Dicke abgeschieden wird, die in der Größenordnung von 50 - 100 % der Breite der Graben- und Reliefstruktur entspricht.

5. Verfahren nach Anspruch 1, **dadurch gekennzeichnet, dass** das V-Ätzen durch plasmachemisches Ätzen erfolgt.

6. Verfahren nach Anspruch 5, **dadurch gekennzeichnet, dass** die Ätzrate des Ätzschrittes so eingestellt wird, dass diese in die Tiefe der Graben- und Reliefstruktur gegenüber der Ätzrate an der Oberfläche des Halbleitersubstrates (1) deutlich abnimmt.

7. Verfahren nach einem der Ansprüche 1 bis 3, **dadurch gekennzeichnet, dass** die erste Füllschicht (2) aus einem amorph abgeschiedenen Polysilizium besteht.

8. Verfahren nach Anspruch 7, **dadurch gekennzeichnet, dass** die erste Füllschicht (2) nach der V-Ätzung durch Gasphasendiffusion dotiert wird.

9. Verfahren nach einem der Ansprüche 1 bis 3, **dadurch gekennzeichnet, dass** die erste Füllschicht (2) aus SiO2 besteht.

10. Verfahren nach einem der Ansprüche 1 bis 3, **dadurch gekennzeichnet, dass** die erste Füllschicht aus Metall besteht.

11. Verfahren nach Anspruch 10, **dadurch gekennzeichnet, dass** die Metallschicht als Doppelschicht, bestehend aus einer Kontaktbarriereschicht und einer metallischen Füllschicht, ausgebildet ist.

12. Verfahren nach Anspruch 1 und 4, **dadurch gekennzeichnet, dass** die zweite Füllschicht (3) aus einem amorph abgeschiedenen hochdotiertem Polysilizium besteht.

13. Verfahren nach Anspruch 12, **dadurch gekennzeichnet, dass** das Polysilizium mit As dotiert ist.

14. Verfahren nach Anspruch 1 und 4, **dadurch gekennzeichnet, dass** die zweite Füllschicht (3) aus SiO2 besteht.

15. Verfahren nach Anspruch 1 und 4, **dadurch gekennzeichnet, dass** die zweite Füllschicht (3) aus Metall besteht.

## Claims

1. Method for filling trench and relief structures formed in a semiconductor substrate, in which the trench and relief structures are coated in a first deposition process with a first primary filling layer (2) with high conformity and minimal roughness, a v-etching reaching down to a predetermined depth of the trench structure being subsequently performed in order to produce a v-profile, and a second primary filling layer (3) being deposited with high conformity and minimal roughness, **characterized in that**, after the deposition of the first filling layer (2) and before the formation of the v-profile, there is deposited on the first primary filling layer a filling auxiliary layer (4), which is subsequently removed again in a planarizing manner on the substrate surface, **in that**, in order to form the v-profile, a predominantly isotropically acting wet-chemical etching step is carried out until the complete removal of the first filling layer (2) on the surface of the semiconductor substrate (1), **in that** a wet-chemical etching is subsequently carried out, by which the material of the filling auxiliary layer (4) that has remained in the trench and relief structure is completely removed again with high selectivity with respect to the first filling layer (2), and **in that** the second primary filling layer (3) is then deposited until the trench and relief structure is completely closed.

2. Method according to Claim 1, **characterized in that** the filling auxiliary layer (4) comprises doped SiO₂.

3. Method according to either of Claims 1 and 2, **characterized in that** the first filling layer is deposited with a thickness corresponding to about 10 - 30% of the width of the trench and relief structure.

4. Method according to Claim 1, **characterized in that** the second filling layer (3) is deposited with a thickness corresponding to the order of magnitude of 50 - 100% of the width of the trench and relief structure.

5. Method according to Claim 1, **characterized in that** the v-etching is effected by plasma-chemical etching.

6. Method according to Claim 5, **characterized in that** the etching rate of the etching step is set such that it significantly decreases into the depth of the trench and relief structure compared with the etching rate at the surface of the semiconductor substrate (1).

7. Method according to one of Claims 1 to 3, **characterized in that** the first filling layer (2) comprises an amorphously deposited polysilicon.

8. Method according to Claim 7, **characterized in that** the first filling layer (2) is doped after the v-etching by gas phase diffusion.

9. Method according to one of Claims 1 to 3, **characterized in that** the first filling layer (2) comprises SiO₂.

10. Method according to one of Claims 1 to 3, **characterized in that** the first filling layer (2) comprises metal.

11. Method according to Claim 10, **characterized in that** the metal layer is formed as a double layer, comprising a contact barrier layer and a metallic filling layer.

12. Method according to Claims 1 and 4, **characterized in that** the second filling layer (3) comprises an amorphously deposited, highly doped polysilicon.

13. Method according to Claim 12, **characterized in that** the polysilicon is doped with As.

14. Method according to Claims 1 and 4, **characterized in that** the second filling layer (3) comprises SiO₂.

15. Method according to Claims 1 and 4, **characterized in that** the second filling layer (3) comprises metal.

## Revendications

1. Procédé de remplissage de structures de tranchées et de reliefs formées dans un substrat de semi-conducteur, dans lequel les structures de tranchées et de reliefs sont revêtues d'une première couche primaire de remplissage (2) à haute conformité et à rugosité minimale par une première opération de dépôt, dans lequel on effectue ensuite une gravure en V pénétrant jusqu'à une profondeur prédéterminée de la structure de tranchées pour produire un profil en V et on dépose une deuxième couche primaire de remplissage (3) à haute conformité et à rugosité minimale, **caractérisé en ce qu'**après le dépôt de la première couche de remplissage (2) et avant la formation du profil en V sur la première couche primaire de remplissage, on dépose une couche de remplissage auxiliaire (4) qui est ensuite de nouveau enlevée par planarisation sur la surface du substrat, **en ce que** l'on exécute pour réaliser le profil en V une étape de gravure chimique humide agissant de manière essentiellement isotrope jusqu'à l'enlèvement complet de la première couche de remplissage (2) sur la surface du substrat de semi-conducteur (1), **en ce que** l'on exécute ensuite une gravure chimique humide qui enlève de nouveau complètement avec une grande sélectivité par rapport à la première couche de remplissage (2) la matière de la couche de remplissage auxiliaire (4) restant dans la structure de tranchées et de reliefs, et **en ce que** l'on dépose ensuite la deuxième couche primaire de remplissage (3), jusqu'à ce que la structure de tranchées et de reliefs soit complètement fermée.

2. Procédé selon la revendication 1, **caractérisé en ce que** la couche de remplissage auxiliaire (4) se compose de SiO₂ dopé.

3. Procédé selon l'une quelconque des revendications 1 et 2, **caractérisé en ce que** l'on dépose la première couche de remplissage en une épaisseur, qui correspond environ à 10 - 30% de la largeur de la structure de tranchées et de reliefs.

4. Procédé selon la revendication 1, **caractérisé en ce que** l'on dépose la deuxième couche de remplissage (3) en une épaisseur qui correspond en ordre de grandeur à 50 - 100% de la largeur de la structure de tranchées et de reliefs.

5. Procédé selon la revendication 1, **caractérisé en ce que** la gravure en V est effectuée par gravure chimique au plasma.

6. Procédé selon la revendication 5, **caractérisé en ce que** l'on règle la vitesse de gravure de l'étape de gravure de telle façon que cette vitesse dans la profondeur de la structure de tranchées et de reliefs diminue nettement par rapport à la vitesse de gravure à la surface du substrat de semi-conducteur (1).

7. Procédé selon l'une quelconque des revendications 1 à 3, **caractérisé en ce que** la première couche de remplissage (2) se compose de polysilicium déposé sous forme amorphe.

8. Procédé selon la revendication 7, **caractérisé en ce que** la première couche de remplissage (2) est dopée par diffusion en phase gazeuse après la gravure en V.

9. Procédé selon l'une quelconque des revendications 1 à 3, **caractérisé en ce que** la première couche de remplissage (2) se compose de SiO₂.

10. Procédé selon l'une quelconque des revendications 1 à 3, **caractérisé en ce que** la première couche de remplissage se compose de métal.

11. Procédé selon la revendication 10, **caractérisé en ce que** la couche de métal est formée en une double couche, se composant d'une couche de barrière de contact et d'une couche de remplissage métallique.

12. Procédé selon la revendication 1 et 4, **caractérisé en ce que** la deuxième couche de remplissage (3) se compose de polysilicium fortement dopé déposé sous forme amorphe.

13. Procédé selon la revendication 12, **caractérisé en ce que** le polysilicium est dopé avec As.

14. Procédé selon la revendication 1 et 4, **caractérisé en ce que** la deuxième couche de remplissage (3) se compose de SiO₂.

15. Procédé selon la revendication 1 et 4, **caractérisé en ce que** la deuxième couche de remplissage (3) se compose de métal.
